(19) **Europäisches Patentamt / European Patent Office / Office européen des brevets**

(11) **EP 1 817 368 B1**

(12) **EUROPÄISCHE PATENTSCHRIFT**

(45) Veröffentlichungstag und Bekanntmachung des Hinweises auf die Patenterteilung:
**06.07.2011 Patentblatt 2011/27**

(21) Anmeldenummer: **05801728.6**

(22) Anmeldetag: **14.10.2005**

(51) Int Cl.:
***B41M 5/26*** (2006.01)

(86) Internationale Anmeldenummer:
**PCT/EP2005/055281**

(87) Internationale Veröffentlichungsnummer:
**WO 2006/042829 (27.04.2006 Gazette 2006/17)**

(54) **PIGMENT FÜR LASERBESCHRIFTBARE KUNSTSTOFFE UND DESSEN VERWENDUNG**

PIGMENT FOR LASER-WRITABLE PLASTIC MATERIALS AND USE THEREOF

PIGMENT POUR MATIERES PLASTIQUES INSCRIPTIBLES AU LASER, ET SON UTILISATION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **15.10.2004 DE 102004050480**

(43) Veröffentlichungstag der Anmeldung:
**15.08.2007 Patentblatt 2007/33**

(73) Patentinhaber: **Chemische Fabrik Budenheim KG 55257 Budenheim (DE)**

(72) Erfinder:
• **MARKMANN, Joachim 55452 Dorsheim (DE)**
• **WISSEMBORSKI, Rüdiger 55435 Gau-Algesheim (DE)**

(74) Vertreter: **WSL Patentanwälte Postfach 6145 65051 Wiesbaden (DE)**

(56) Entgegenhaltungen:
**DE-A1- 10 255 155      DE-A1- 19 707 297**
**DE-A1- 19 905 358      FR-A- 2 568 238**
**US-A- 5 717 018**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 817 368 B1

**Beschreibung**

Die Erfindung betrifft Pigmente für laserbeschriftbare Kunststoffe in der Form teilchenförmiger, lichtsensitiver Verbindungen, die unter dem Einfluß von Laserlicht ihre Farbe verändern bzw. zu einer Farbänderung im Kunststoff führen.

Seit längerer Zeit befaßt sich die Forschung mit der Entwicklung laserbeschriftbarer Kunststoffe, da Laserlicht zu sehr feinen Strahlen gebündelt werden kann, was man zur Erzeugung von Schrift und Bild auf Kunststoffgegenständen ausnutzen möchte. Die meisten Kunststoffe sind aber als solche nicht beschriftbar, da sie Laserlicht nicht absorbieren. Daher setzt man dem Kunststoff teilchenförmige, lichtsensitive Pigmente zu, die unter dem Einfluß von Laserlicht ihre Farbe verändern. Diese Veränderung kann darin bestehen, daß das Pigment selbst unter Absorption von Laserlicht seine Farbe durch chemische Reaktion oder physikalischen Übergang in eine andere Modifikation verändert oder aber durch Übertragung von absorbierter Lichtenergie auf den benachbarten Kunststoff diesen zersetzt oder anderweitig zu einem Farbumschlag veranlaßt.

Die in der Vergangenheit zu diesem Zweck untersuchten Pigmente waren in den meisten Fällen Metalloxide, wie Titandioxid gemäß der EP-A-330 869 oder Gemische solcher Metalloxide, wie sie in der EP 105 451 beschrieben sind. Auch bestimmte Metallverbindungen wurden bereits als Pigmente für laserbeschriftbare Kunststoffgegenstände genannt, wie Kupfersalze (EP-A-706 897) alleine oder in Gegenwart anderer Metallverbindungen (US-A-5 489 639), die nur in solch geringen Konzentrationen zugesetzt werden dürfen, daß sie das als Pigment zugesetzte Kupfersalz nicht stören, und unter dem Einfluß von Laserlicht ihre Farbe nicht verändern.

Die zur Laserbeschriftbarkeit führenden Pigmente ergeben häufig nur einen ungenügenden Farbunterschied gegenüber der Kunststoffmatrix und damit einen schlechten Farbkontrast und schlechte Lesbarkeit der Beschriftung. In anderen Fällen verändert sich der anfangs akzeptable Farbkontrast mit der Zeit, so daß die Beschriftung mehr oder weniger verschwindet. Bei Zusatz zunehmender Pigmentmengen besteht außerdem die Gefahr einer unerwünschten Veränderung der Kunststoffeigenschaften.

Die der Erfindung zugrundeliegende Aufgabe bestand somit darin, Pigmente zu finden, die die Laserbeschriftbarkeit, insbesondere den Farbkontrast, verbessern und/oder dauerhafter machen, ohne die Kunststoffeigenschaften in unannehmbarer Weise zu beeinträchtigen.

Diese Aufgabe wird überraschenderweise dadurch gelöst, daß die Pigmente für laserbeschriftbare bzw. -markierbare Kunststoffe mit den eingangs genannten Merkmalen aus wenigstens einer salzartigen, wenigstens zwei verschiedene Kationen umfassenden Verbindung oder einem zu wenigstens einer solchen salzartigen Verbindung mit wenigstens zwei verschiedenen Kationen, vorzugsweise, aber nicht ausschließlich, umsetzbaren Verbindungsgemisch bestehen, wobei wenigstens eines der Kationen aus einer Gruppe (A) der Elemente Ti, Cr, Mn, Fe, Co, Ni, Cu, Zn, Y, Zr, Nb, Mo, Ag, Sn, Sb, La, Pr, Ta, W und Ce ausgewählt ist und wenigstens ein weiteres Kation aus einer Gruppe (B) der Elemente der 3. bis 6. Periode der II. und III. Hauptgruppe, der 5. bis 6. Periode der IV. Hauptgruppe sowie der 4. bis 5. Periode der III. bis VIII. Nebengruppe oder den Lanthaniden des Periodensystems der Elemente ausgewählt ist.

Nach der technischen Lehre der vorliegenden Erfindung müssen also salzartige Verbindungen so ausgewählt und miteinander kombiniert werden, daß aus jeder der beiden oben definierten Gruppen A und B jeweils mindestens eine salzartige Verbindung mit mindestens einem für diese Gruppe aufgeführten Kation ausgewählt wird, wobei wenigstens ein ausgewähltes Kation aus der einen Gruppe verschieden von wenigstens einem ausgewählten Kation aus der anderen Gruppe sein muß.

Unter einer salzartigen Verbindung versteht man hier im Sinne der Erfindung Verbindungen, die in Wasser wenigstens teilweise in Kationen und Anionen dissoziieren bzw. aus einem Säurerest und einem Basenrest bestehen.

Wenn andererseits hier von einer Farbveränderung die Rede ist, kann diese ein Umschlagen von einem Farbton in einen anderen, wie beispielsweise von Gelb nach Rot oder von Transparent nach Schwarz sein. Im Sinne der Erfindung soll unter diesem Begriff aber auch eine Helligkeitsveränderung, beispielsweise von Hellbraun nach Dunkelbraun und/oder eine Farbänderung im Kunststoff verstanden werden.

Der Begriff "teilchenförmig" soll bedeuten, daß das Pigment in Form feiner fester Teilchen vorliegt, wobei sich quantitative Angaben auf die mittlere Teilchengröße ($d_{50}$) und auf die Teilchengröße der Primärteilchen bezieht. Die Größe der Primärteilchen liegt im Nanometer- bis Mikrometerbereich. Geeignete Primärteilchen haben mittlere Teilchengröße ($d_{50}$) kleiner als 10 $\mu$m, vorzugsweise kleiner als 5 $\mu$m.

Der Teilchendurchmesser wird für die Zwecke dieser Erfindung bestimmt durch übliche Methoden wie Lichtstreuung, Mikroskopie bzw. Elektronenmikroskopie, zählende Flussmessungen an dünnen Spalten, Sedimentationsverfahren oder weiteren kommerziell erhältlichen Verfahren.

Wenn die Pigmente nach der Erfindung den obigen Voraussetzungen bezüglich der Auswahl und Kombination der Kationen der salzartigen Verbindungen entsprechen, können diese Pigmente, ohne den Erfindungsgedanken zu verlassen, zusätzlich weitere Kationen, insbesondere solche von Elementen der 2. bis 5. Periode der I. Hauptgruppe enthalten. Auch ist es möglich, den Pigmenten zusätzlich anorganische Oxide und/oder weitere farbgebende Additive und/oder übliche, bestimmte Eigenschaften modifizierende Additive zuzusetzen, wie UV-Stabilisatoren, Stabilisatoren gegen Verwitterung, thermische und thermooxidative Angriffe, zur Verbesserung der hydrolytischen und azidolytischen Beständigkeit, Gleitmittel, Entformungshilfen, kristallisationsregulierende Substanzen und Nukleierungsmittel, Füllstoffe, Weichmacher und andere Zusatzstoffe.

Die obige Definition des Erfindungsgedankens schließt zwei Ausführungsformen ein, die alternativ oder in Kombination miteinander verwendet werden können. Die eine Ausführungsform besagt, daß die für die erfindungsgemäßen Pigmente verwendeten salzartigen Verbindungen als solche wenigstens zwei verschiedene Kationen besitzen, beispielsweise durch Umsetzung wenigstens zweier einfacher Salze (mit jeweils einem Kation) entstanden sind und als Mischsalze in den Handel kommen. Die andere Ausführungsform bedient sich der gleichen Auswahl von Kationen wie die erste Ausführungsform, besteht aber aus einem noch nicht miteinander umgesetzten, handelsfähigen Gemisch einfacher Salze. Diese Ausführungsform ist besonders zweckmäßig, wenn bei den nachfolgenden Verarbeitungstemperaturen, etwa beim Aufschmelzen des Kunststoffes oder bei anderer Verschärfung einer Verfahrensbedingung, die in der Mischung vorliegenden einfachen Salze zu Mischsalzen, also neuen Umsetzungsprodukten reagieren.

Bei der letzteren Ausführungsform gibt es wiederum zwei Möglichkeiten. Die in dem Gemisch enthaltenen einfachen salzartigen Verbindungen können vor der Zugabe zu dem laserbeschriftbar zu machenden Kunststoff miteinander umgesetzt werden, um eine salzartige Verbindung mit Kationen nach den erfindungsgemäßen Auswahlregeln zu bilden, worauf das Umsetzungsprodukt als Pigment für die Zumischung zu Kunststoffen benutzt werden kann. Nach einer anderen Ausführungsform wird das Gemisch der einfachen Salze in den laserbeschriftbar zu machenden Kunststoff gemischt, bevor eine Umsetzung erfolgt. Anschließend reagieren beim Erhitzen der Grundmasse die einfachen salzartigen Verbindungen miteinander und ergeben gleiche oder ähnliche Mehrfachsalze, die denen im ersten Teil dieses Beispiels gleichen oder wenigstens ähneln.

Der mit Pigmenten nach der Erfindung erhaltene Farbunterschied kann als lokal unterschiedliche Leuchtdichte, als lokal unterschiedliche Farbwerte z. B. im CIELab-System oder als lokal unterschiedliche Farbwerte im RGB System erfaßt werden. Diese Effekte können bei unterschiedlichen Lichtquellen auftreten.

Die Auswahl der Komponenten aus den Gruppen A und B der Elemente erfolgt in der Regel so, daß diese im Wellenlängenbereich des zur Verfügung stehenden Laserlichts eine möglichst starke Absorption aufweisen.

Die Wellenlängenbereiche des eingesetzten Laserlichts sind grundsätzlich keinen Beschränkungen unterworfen. Geeignete Laser haben im allgemeinen eine Wellenlänge im Bereich von 157 nm bis 10,6 $\mu$m, vorzugsweise im Bereich von 532 nm bis 10,6 $\mu$m. Beispielsweise seien hier $CO_2$-Laser (10,6 $\mu$m) und Nd:YAG-Laser (1064 nm) oder gepulste UV-Laser erwähnt.

Typische Excimerlaser weisen folgende Wellenlänge auf: $F_2$-Excimerlaser (157 nm), ArF-Excimerlaser (193 nm), XeCl-Excimerlaser (308 nm), XeF-Excimerlaser (351 nm), frequenzvervielfachte Nd:YAG-Laser mit Wellenlängen von 532 nm (frequenzverdoppelt) von 355 nm (frequenzverdreifacht) oder 265 nm (frequenzvervierfacht). Besonders bevorzugt werden Nd:YAG-Laser (1064 bzw. 532 nm) und $CO_2$-Laser eingesetzt. Die Energiedichten der erfindungsgemäß eingesetzten Laser liegen im allgemeinen im Bereich von 0,3 mJ/cm$^2$ bis 50 J/cm$^2$, vorzugsweise 0,3 mJ/cm$^2$ bis 10 J/cm$^2$. Bei der Verwendung von gepulsten Lasern liegt die Pulsfrequenz im allgemeinen im Bereich von 1 bis 30 kHz.

Lichtsensitive Verbindungen im Sinne dieser Beschreibung sind organische oder anorganische salzartige Verbindungen mit den oben definierten Kombinationen unterschiedlicher Kationen oder Mischungen aus salzartigen Verbindungen mit den oben definierten Kombinationen unterschiedlicher Kationen, die unter dem Einfluß einer Laserlichtquelle an der belichteten Stelle ihre Farbe ändern und/oder zu einer Farbänderung im Kunststoff führen.

Diese Verbindungen können klassische Salze mit definierter Stöchiometrie aus einem oder mehreren Anionen mit mehreren, mindestens jedoch zwei von unterschiedlichen Elementen abgeleiteten Kationen sein, es kann sich aber auch um nicht stöchiometrisch zusammengesetzte Verbindungen handeln, die mindestens zwei von unterschiedlichen Elementen abgeleitete Kationen aufweisen.

Die Anionen unterliegen grundsätzlich keinen Beschränkungen, solange damit der Aufbau von Verbindungen mit Kationen von mindestens zwei unterschiedlichen Elementen möglich ist. Bevorzugt werden Anionen eingesetzt, die mindestens zwei unterschiedliche Elemente enthalten.

Besonders bevorzugte Komponenten weisen als Anionen Oxoanionen des Periodensystems auf sowie die Anionen der organischen Carbonsäuren sowie der Kohlensäure, sofern sich mit ihnen Mischverbindungen mit mehreren Kationen realisieren lassen. Besonders bevorzugte Komponenten weisen als Anionen phosphorhaltige Oxoanionen auf.

Bevorzugt sind solche Kombinationen, bei denen die unbelichtete Verbindung im Bereich der verwendeten Lichtwellenlänge absorbiert.

Bevorzugt sind weiterhin solche Kombinationen, bei denen durch Variation der Molverhältnisse der Kationen die Eigenfarbe der unbelichteten Verbindung eingestellt werden kann.

In einer Ausprägung der Erfindung weist die unbelichtete Komponente eine beliebige Eigenfarbe und die belichtete Komponente einen möglichst deutlichen farblichen Unterschied dazu auf. Im CIELab-System bedeutet dieses das Auftreten eines hohen Wertes für dE*, wobei

$$dE^* = 2\sqrt{(L^*_1 - L^*_2)^2 + (a^*_1 - a^*_2)^2 + (b^*_1 - b^*_2)^2}$$

bedeutet; dabei steht Index 1 für die unbelichtete, Index 2 für die belichtete Formmasse.

Bei dem CIELab-System handelt es sich um ein von der Internationalen Beleuchtungskommission (Commission Internationale d'Eclairage) 1976 festgelegten Farbraum, wobei L* = Helligkeit, a* = Rot-Grün-Farbinformation und b* = Gelb-Blau-Information bedeuten.

In einer bevorzugten Ausführungsform der Erfindung weist die unbelichtete Verbindung eine möglichst hohe Helligkeit (also einen möglichst hohen Helligkeitswert L* im CIELab-Farbraum) und eine möglichst geringe Eigenfarbe (also eine möglichst geringe Abweichung von der schwarz-weiß-Achse: betragsmäßig möglichst geringes a*, betragsmäßig möglichst geringes b*) auf. In diesem Fall soll die belichtete Verbindung eine möglichst geringe Helligkeit (möglichst niedriger Helligkeitswert L*) und dennoch eine möglichst geringe Eigenfarbe (betragsmäßig möglichst geringes a*, betragsmäßig möglichst geringes b*) aufweisen.

In einer anderen bevorzugten Ausführungsform der Erfindung weist die unbelichtete Komponente eine möglichst hohe Helligkeit (möglichst hoher Helligkeitswert L* im CIELab-Farbraum) und eine möglichst geringe Eigenfarbe (möglichst geringe Abweichung von der schwarz-weiß-Achse: betragsmäßig möglichst geringes a*, betragsmäßig möglichst geringes b*) auf. In diesem Fall soll die belichtete Komponente eine möglichst deutliche Eigenfarbe (betragsmäßig möglichst hohes a* und/oder b*) aufweisen.

In einer bevorzugten Ausführungsform der erfindungsgemäßen Zusammensetzung weisen die Anionen der obigen Komponente die allgemeine Formel $A_aO_o(OH)_y^{z-}$ auf, worin

A = drei- oder fünfwertiger Phosphor, vierwertiges Molybdän oder sechswertiges Wolfram bedeuten,

a, o und z unabhängig voneinander ganze Zahlen mit Werten von 1 - 20 bedeuten, und y eine ganze Zahl mit Werten zwischen 0 - 10 ist.

In einer weiteren bevorzugten Ausführungsform der erfindungsgemäßen Zusammensetzung weist das Pigment mindestens eine Kombination aus zwei unterschiedlichen Elementen der Gruppe bestehend aus Kupfer, Zinn, Antimon und Eisen auf.

In eine besonders bevorzugten Ausführungsform der erfindungsgemäßen Zusammensetzung weist das Pigment Anionen der Phosphor(V)- und/oder Phosphor(III)-säure, deren Kondensationsprodukte oder gegebenenfalls mit weiteren Hydroxidionen und als Kationen Cu und Fe oder Cu und Sn oder Cu und Sb oder Sn und Fe auf.

Die erfindungsgemäßen Pigmente werden zweckmäßig für die Erzeugung von Laserbeschriftbarkeit in Polymeren, wie beispielsweise in teilkristallinen Thermoplasten, besonders von Polyacetalen, Polyestern, Polyamiden, Polyarylenethern, Polyarylensulfiden, Polyethersulfonen, Polyaryletherketonen, Polyolefinen und Kombinationen hiervon benutzt.

Die erfindungsgemäßen Pigmente können zum Beschriftbarmachen von Kunststoffen auf den verschiedensten technischen Gebieten eingesetzt werden. Die Verarbeitung der die Pigmente enthaltenden Formmassen kann in bekannter Weise durch Extrudieren, Spritzguß, Vakuumformen, Blasformen oder Schäumen erfolgen. Die so erhaltenen Formteile werden häufig in der Computer-, Elektro-, Elektronik-, Haushaltswaren- und Kraftfahrzeugindustrie eingesetzt. Beispiele der erhaltenen laserbeschriftbaren Kunststoffgegenstände sind beispielsweise Tastaturen, Kabel, Leitungen, Zierleisten, Funktionsteile im Heizungs-, Lüftungs- und Kühlbereich, Schalter, Stecker, Hebel und Griffe und viele andere Teile im Baubereich oder Elektronikbereich. Ein weiteres Anwendungsgebiet sind die Kunststoffmarken zur individuellen Kennzeichnung von Tieren, insbesondere von Nutztieren, wie Geflügelringe, Cattle Tags oder Ohrmarken. Die Beschriftung unter Verwendung erfindungsgemäßer Pigmente ist sehr dauerhaft.

Beispiel 1

20% Kupferhydroxidphosphat und 80% Zinnphosphat werden in einem Mischer der Firma Turbula 20 Minuten intensiv gemischt. Dann wird das Produkt in einem Extruder als 3%ige Mischung eingesetzt. Nach dem Extrudieren wird eine RBA-Analyse des Salzes durchgeführt. Die RBA-Analyse zeigt ein Beugungsspektrum, das sich deutlich von dem der Ausgangssalze unterscheidet.

Beispiel 2

20% Kuperhydroxidphosphat und 80% Zinnphosphat werden vermischt und als 20%ige Suspension in Ortwasser aufgekocht. Anschließend wird die Suspension abfiltriert und getrocknet. Nach dem Trocknen bis zu einem GV unter 5% wird das Endprodukt vermahlen. Der D50 des so hergestellten Endproduktes liegt unter 3 $\mu$m. Das Endprodukt zeigt bei der Analyse mittels Röntgenbeugung eine deutliche Abweichung von der RB-Analyse der Ausgangsprodukte.

Die L,a,b-Werte des Endproduktes zeigen eine deutliche Abweichung zu den Ausgangsprodukten. Das Endprodukt zeigt einen a-Wert von -2,1 auf und ist damit deutlich heller als das Kupferhydroxidphosphat, welches a-Werte von -4 bis -7 aufweist (gemessen wurde mit einem Gerät der Firma Macbeth Color Eye 3000). Die Beschriftbarkeit mit Laserlicht zeigt K-Werte von über 4 und ist damit im Bereich von KHP, ohne die Nachteile der Grünfärbung aufzuzeigen.

Beispiel 3

50% Kuperhydroxidphosphat und 50% Zinnphosphat werden vermischt und als 20%ige Suspension in Ortswasser aufgekocht. Anschließend wird die Suspension abfiltriert und getrocknet. Nach dem Trocknen bis zu einem GV unter 3% wird das Endprodukt vermahlen. Der D50 des so hergestellten Endproduktes liegt unter 5 µm. Das Endprodukt zeigt bei der Analyse mittels Röntgenstrahlenbeugung eine deutliche Abweichung von der RB-Analyse der Ausgangsprodukte. Die L,a,b-Werte des Endproduktes zeigen eine deutliche Abweichung zu den Ausgangsprodukten. Das Endprodukt zeigt einen a-Wert von 2,5 auf und ist damit deutlich heller als das Kupferhydroxidphosphat, welches L-Werte von 5 bis 7 aufweist.

Beispiel 4

50% Eisenphosphit werden mit 50% Zinnphosphat gemischt und dann als 10%ige Suspension in Ortswasser aufgekocht und 30 Minuten am Sieden gehalten. Diese Suspension wird dann abgekühlt und separiert. Der Filterkuchen wird getrocknet und anschließend fein vermahlen. Das Endprodukt wird einer RBA-Analyse unterzogen. Es zeigt völlig eigenständige Kennlinien, die nicht mit den Kennlinien der Ausgangsprodukte vergleichbar sind. Das Material zeigt gute Eigenschaften als Pigment zur Laserbeschriftung. Der hohe Rotanteil, gemessen im a-Wert, der für das Eisenphosphit typisch ist, wird deutlich herabgesetzt. Die beim Beschriften mit Laserlicht (Nd-YAG-Laser mit einer Wellenlänge von 1064 nm) erzeugte Schrift weist einen hohen Anteil an schwarzem Pigment auf.

Zur Ermittlung des technischen Effektes der vorliegenden Erfindung wurden unter Verwendung der Produkte der Beispiele 4 bis 9 und der Vergleichsbeispiele 2 und 3 als Pigment zur Erzielung der Laserbeschriftbarkeit herangezogen. In der nachfolgenden Tabelle finden sich die Rezepturen der obigen Beispiele nach der Erfindung sowie von Vergleichsbeispielen.

Tabelle

| | Komp. (A) (Gew.-%) | | Komp. (B) (Gew.-%) | | Komp. (C) (Gew.-%) | | Komp. (D) (Gew.-%) | | | Lichtemp-findlichkeit | Matrix-helligkeit | Matrix-farbe | Markierungsdunkelheit | Markierungsfarbe | Kontrast | Topologie |
|---|---|---|---|---|---|---|---|---|---|---|---|---|---|---|---|---|
| V2 | 98,35 | POM | 0,2 | CuFeP | 0 | - | 1,45 | - | $D_{POM}$ | + | 0 | dunkelgrau | + | schwarz-braun | + | 0 |
| 4 | 98,35 | POM | 0,2 | CuSnP | 0 | - | 1,45 | - | $D_{POM}$ | + | + | hell | + | schwarz-grau | + | 0 |
| 5 | 97,35 | POM | 0,2 | CuFeP | 0 | - | 2,45 | $\mu$-$TiO_2$ | $D_{POM}$ | 0 | + | weiß | 0 | schwarz-braum | + | 0 |
| 6 | 97,35 | POM | 0,2 | CuSnP | 0 | - | 2,45 | $\mu TiO_2$ | $D_{POM}$ | 0 | + | weiß | 0 | schwarz-grau | + | 0 |
| 7 | 98,95 | PBT | 0,2 | CuFeP | 0 | - | 0,85 | - | $D_{PBT}$ | + | 0 | hellgrau | + | schwarz-braun | + | + |
| 8 | 98,95 | PBT | 0,2 | CuSnP | 0 | - | 0,85 | - | $D_{PBT}$ | 0 | 0 | hell | + | schwarz-grau | + | + |
| 9 | 98,75 | PBT | 0,2 | CuFeP | 0,2 | $n$-$TiO_2$ | 0,85 | - | $D_{PBT}$ | + | + | hellgrau | + | schwarz-braun | + | + |
| V3 | 98,15 | PBT | 0 | - | 0 | - | 1,85 | $\mu$-$TiO_2$ | $D_{PBT}$ | 0 | + | weiß | - | grau | - | - |

POM = Hostaform C 9021 von Ticona GmbH, Kelsterbach, Deutschland
PBT = Celanex 2003 von Ticona GmbH, Kelsterbach, Deutschland

**Patentansprüche**

1. Pigment für laserbeschriftbare Kunststoffe in der Form teilchenförmiger lichtsensitiver Verbindungen, die unter dem Einfluß von Laserlicht ihre Farbe verändern und/oder zu einer Farbänderung im Kunststoff führen, **dadurch gekennzeichnet, daß** die Pigmente aus wenigstens einem wenigstens zwei verschiedene Kationen umfassenden Mischsalz oder einem zu wenigstens einem solchen Mischsalz mit wenigstens zwei verschiedenen Kationen umsetzbaren Verbindungsgemisch bestehen, wobei wenigstens eines der Kationen aus einer Gruppe (A) der Elemente Ti, Cr, Mn, Fe, Co, Ni, Cu, Zn, Y, Zr, Nb, Mo, Ag, Sn, Sb, La, Pr, Ta, W und Ce ausgewählt ist und wenigstens ein weiteres Kation aus einer Gruppe (B) der Elemente der 3. bis 6. Periode der II. und III. Hauptgruppe, der 5. bis 6. Periode der IV. Hauptgruppe sowie der 4. bis 5. Periode der III. bis VIII. Nebengruppe und der Lanthaniden des Periodensystems der Elemente ausgewählt ist und wobei die Anionen des Pigments die allgemeine Formel $A_aO_o(OH)_y{}^{z-}$ besitzen, worin A drei- bis fünfwertiger Phosphor, vierwertiges Molybdän oder sechswertiges Wolfram bedeuten, a, o und z unabhängig voneinander ganze Zahlen im Bereich von 1-20 bedeuten und y eine ganze Zahl zwischen 0 und 10 ist.

2. Pigment nach Anspruch 1, **dadurch gekennzeichnet, daß** das Verbindungsgemisch durch Erwärmen zu der salzartigen Verbindung mit wenigstens zwei verschiedenen Kationen umsetzbar ist.

3. Pigment nach Anspruch 1 oder 2, **dadurch gekennzeichnet, daß** seine mittlere Teilchengröße ($d_{50}$) kleiner als 10 $\mu$m, vorzugsweise kleiner als 5 $\mu$m ist.

4. Pigment nach einem der Ansprüche 1 bis 3, **dadurch gekennzeichnet, daß** es neben zwei unterschiedlichen Kationen aus den Gruppen A und B weitere Kationen von Elementen der 2. bis 5. Periode der I. Hauptgruppe enthält.

5. Pigment nach einem der Ansprüche 1 bis 4, **dadurch gekennzeichnet, daß** seine salzartigen Verbindungen als Anionen Oxoanionen des Periodensystems, Anionen von organischen Carbonsäuren oder Anionen der Kohlensäure besitzen.

6. Pigment nach Anspruch 5, **dadurch gekennzeichnet, daß** seine Anionen phosphorhaltige Oxoanionen enthalten.

7. Pigment nach einem der Ansprüche 1 bis 6, **dadurch gekennzeichnet, daß** seine Kationen aus Kupfer, Zinn, Antimon und/oder Eisen bestehen.

8. Pigment nach einem der Ansprüche 1 bis 7, **dadurch gekennzeichnet, daß** die Anionen seiner salzartigen Verbindungen aus Phosphor(V)-Säure und/oder Phosphor(III)-Säure oder deren Kondensationsprodukten, gegebenenfalls mit weiteren Hydroxylionen, und seine Kationen aus Cu und Fe oder Cu und Sn oder Cu und Sb oder Sn und Fe bestehen.

9. Pigment nach einem der Ansprüche 1 bis 8, **dadurch gekennzeichnet, daß** die Verbindungen der Gruppen A und B so miteinander kombiniert werden, daß die unbelichtete Kombination dieser Verbindungen im Bereich der zu verwendenden Lichtwellenlänge absorbiert.

10. Verwendung eines Pigments nach einem der Ansprüche 1 bis 9 zur Erzeugung von Laserbeschriftbarkeit von Kunststoffen, insbesondere Thermoplasten.

**Claims**

1. A pigment for laser-writable plastic materials in the form of particulate, light-sensitive compounds which under the influence of laser light change their color and/or lead to a color change in the plastic material, **characterized in that** the pigments consist of at least one mixed salt including at least two different cations or a compound mixture which can be reacted to afford at least one such mixed salt including at least two different cations, wherein at least one of the cations is selected from a group (A) of the elements Ti, Cr, Mn, Fe, Co, Ni, Cu, Zn, Y, Zr, Nb, Mo, Ag, Sn, Sb, La, Pr, Ta, W and Ce and at least one further cation is selected from a group (B) of the elements of the 3rd to 6th periods of the main groups II and III, the 5th to 6th periods of the main group IV and the 4th to 5th periods of the secondary group III to VIII and the lanthanides of the periodic system of elements and wherein anions of the pigment are of the general formula $A_aO_o(OH)_y{}^{z-}$, wherein A denotes trivalent to pentavalent phosphorus, tetravalent molybdenum or hexavalent tungsten, a, o and z are independently of each other integers in the range of 1 - 20, and y is an integer between 0 - 10.

2. A pigment as set forth in claim 1 **characterized in that** the compound mixture can be reacted by heating to afford the salt-like compound with at least two different cations.

3. A pigment as set forth in claim 1 or claim 2 **characterized in that** its mean particle size ($d_{50}$) is less than 10 $\mu$m, preferably less than 5 $\mu$m.

4. A pigment as set forth in one of claims 1 through 3 **characterized in that** besides two different cations from groups A and B it contains further cations of elements of the 2nd to 5th periods of the main group I.

5. A pigment as set forth in one of claims 1 through 4 **characterized in that** its salt-like compounds as anions have oxoanions of the periodic system, anions of organic carboxylic acids or anions of carbolic acid.

6. A pigment as set forth in claim 5 **characterized in that** its anions contain phosphorus-bearing oxoanions.

7. A pigment as set forth in one of claims 1 through 6 **characterized in that** its cations comprise copper, tin, antimony and/or iron.

8. A pigment set forth in one of claims 1 through 7 **characterized in that** the anions of its salt-like compounds comprise phosphorus (V) acid and/or phosphorus (III) acid or condensation products thereof, optionally with further hydroxyl ions, and its cations comprise Cu and Fe or Cu and Sn or Cu and Sb or Sn and Fe.

9. A pigment as set forth in one of claims 1 through 8 **characterized in that** the compounds of groups A and B are so combined together that the non-irradiated combination of those compounds absorbs in the range of the light wavelength to be used.

10. Use of a pigment as set forth in one of claims 1 through 9 for producing laser-writability of plastic materials, in particular thermoplastic materials.

## Revendications

1. Pigment pour matières synthétiques inscriptibles par laser se présentant sous la forme de composés particulaires photosensibles qui voient leur couleur se modifier sous l'influence d'une lumière laser et/ou qui entrainent un changement de couleur dans la matière synthétique, **caractérisé en ce que** les pigments sont constitués d'au moins un sel mixte comportant au moins deux cations différents ou d'un mélange de composé pouvant être transformés en au moins un tel sel mixte comportant au moins deux cations différents, au moins un des cations étant sélectionnés dans un groupe (A) des éléments Ti, Cr, Mn, Fe, Co, Ni, Cu, Zn, Y, Zr, Nb, Mo, Ag, Sn, Sb, La, Pr, Ta, W et Ce et au moins un autre cation étant sélectionné dans un groupe (B) des éléments des 3ème à 6ème périodes des groupes principaux II et III, des 5ème à 6ème périodes du groupe principal IV ainsi que des 4ème à 5ème périodes des groupes secondaires III à VIII et des lanthanides de la classification périodique des éléments et les anions des pigments ayant la formule générale $A_aO_o(OH)_y^{z-}$, où A est un phosphore trivalent à pentavalent, un molybdène tétravalent ou un tungstène hexavalent, a, o et z étant des nombres entiers indépendamment l'un de l'autre de l'ordre de 1 à 20 et y étant un nombre entier compris entre 0 et 10.

2. Pigment selon la revendication 1, **caractérisé en ce que** le mélange de composés peut être transformé par chauffage en le composé salin comportant au moins deux cations différents.

3. Pigment selon la revendication 1 ou 2, **caractérisé en ce que** sa granularité moyenne ($d_{50}$) est inférieure à 10 $\mu$m, avantageusement inférieure à 5 $\mu$m.

4. Pigment selon l'une des revendications 1 à 3, **caractérisé en ce qu'**il contient, en plus des deux cations différents des groupes A et B, d'autres cations d'éléments des 2ème à 5ème périodes du groupe principal I.

5. Pigment selon l'une des revendications 1 à 4, **caractérisé en ce que** ses composés salins possèdent comme anions des oxoanions de la classification périodique des éléments, des anions d'acides carboniques organiques ou des anions du dioxyde de carbone.

6. Pigment selon la revendication 5, **caractérisé en ce que** ses anions contiennent des oxoanions phosphorés.

7. Pigment selon l'une des revendications 1 à 6, **caractérisé en ce que** ses cations sont constitués de cuivre, d'étain, d'antimoine et/ou de fer.

8. Pigment selon l'une des revendications 1 à 7, **caractérisé en ce que** les anions de ses composés salins sont constitués d'acide phosphorique et/ou d'acide phosphoreux ou de leurs produits de condensation, éventuellement avec d'autres ions hydroxyle et ses cations sont constitués de Cu et de Fe ou de Cu et de Sn ou de Cu et de Sb ou de Sn et de Fe.

9. Pigment selon l'une des revendications 1 à 8, **caractérisé en ce que** les composés des groupes A et B sont combinés l'un à l'autre de telle sorte que la combinaison non exposée de ces composés absorbe dans la gamme de la longueur d'onde à utiliser.

10. Utilisation d'un pigment selon l'une des revendications 1 à 9 pour générer des matières synthétiques, notamment des thermoplastiques, inscriptibles par laser.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 330869 A
- EP 105451 A

- EP 706897 A
- US 5489639 A